# EUROPEAN PATENT APPLICATION

(11) **EP 3 051 299 A1**
(43) Date of publication of application: **03.08.2016**
(21) Application number: 15153415.3
(22) Date of filing: 02.02.2015
(51) Int. Cl.: G01R 15/16, G01R 1/067

(54) **Electrode foil**

(71) Applicant: 3M Innovative Properties Company, St. Paul, MN 55133-3427 (US)
(72) Inventor: Gravermann, Mark, 41812 Erkelenz (DE)
(74) Representative: Müller, Bruno

(57) **Abstract**

Electrode foil (6) comprising
a) an electrode layer (60) comprising
- a sensing electrode portion (100), operable as an electrode of a sensing capacitor for sensing a voltage of an inner conductor (20) of a medium or high voltage power cable (10),
- a first auxiliary electrode portion (200), electrically isolated from the sensing electrode portion.

The electrode foil further comprises
b) a non-conductive carrier film (71) carrying both the sensing electrode portion and the first auxiliary electrode portion, and
c) an adhering surface portion (90) for attaching the electrode foil to an exposed insulation layer (30) of the power cable.

## Description

The invention relates to electrodes for sensors for medium-voltage (MV) or high-voltage (HV) power cables in power distribution networks like national grids.

Such power cables are designed for currents of tens of amperes, and for voltages of kilovolts. These cables typically have an inner conductor for carrying the electrical power, surrounded by a main insulation layer and an outer cable sheath. In order to measure the voltage of the inner conductor versus electrical ground, capacitive sensors are often used. In some of these sensors, a sensing capacitor is formed by the main insulation layer, and potentially other insulation layers, forming the dielectric, by the inner conductor forming the first sensing electrode, and by an electrode arranged on the outer circumference of the main insulation layer forming the second sensing electrode of the sensing capacitor.

In the European patent application EP 2608338 B1 a voltage sensor on a power cable is described which comprises a piece of conductive or semiconductive material, arranged on the insulating layer and operable to form an electrode of a sensing capacitor for sensing voltage of the inner conductor.

While a single sensing electrode is often sufficient to sense the voltage of the inner conductor, one or two further electrodes may be arranged in the vicinity of the sensing electrode such that they shape the electrical field in a suitable manner, e.g. to provide some degree of symmetry to the electric field, or such that they avoid parasitic capacitances. The presence of one or more of such "field-shaping electrodes" or "guard electrodes" can result in a higher accuracy of the voltage sensing by the sensing electrode.

An example of a voltage sensor for a power cable is shown in the international patent application WO 2012/130816 A1. In this disclosure, the measurement apparatus comprises a sensing electrode assembly arranged around the cable, comprising a sensing electrode element connected to a semiconductor layer of the cable, such that a sensing capacitor is formed by the semiconductor layer together with the at least one central conductor and at least the first dielectric layer of the insulated electrical cable. An arrangement for defining an effective sensing area is formed by two additional electrode elements positioned on either side of the sensing electrode element, which are connected to the semiconductor layer of the cable.

Generally, the sensing electrode and a field-shaping electrode should be installed on an insulating layer of the cable, e.g. the main insulation layer, with a well-defined axial distance between them and without being distorted. Hence an installation of the sensing electrode and of a field-shaping electrode on an insulating layer of a power cable can be difficult and time-consuming. It is desirable to maKe the installation process more reliable and quicker. The present invention seeks to address this problem.

The present invention provides an electrode foil comprising
a) an electrode layer comprising a sensing electrode portion, operable as an electrode of a sensing capacitor for sensing a voltage of an inner conductor of a medium or high voltage power cable, and a first auxiliary electrode portion, electrically isolated from the sensing electrode portion,
   characterized in that the electrode foil further comprises
b) a non-conductive carrier film carrying both the sensing electrode portion and the first auxiliary electrode portion, and
c) an adhering surface portion for attaching the electrode foil to an exposed insulation layer of the medium or high voltage power cable.

The arrangement of the sensing electrode and of the first auxiliary electrode on a carrier film, and an adhering surface portion for attaching the electrodes on the insulation layer of an MV/HV cable makes installation of the electrodes quicker and more reliable, because the electrodes do not need to be positioned relative to each other on the insulation. The electrodes can be positioned relative to each other on the carrier film in a factory, potentially in an automated process. This results in a more precise geometry of the arrangement of electrodes, which may be essential for a higher accuracy of the voltage sensor comprising the electrodes. With an electrode foil as described, the installation of electrodes is more reliable because there is no need to assemble the two electrodes in the field under potentially adverse conditions, which may result in undesired geometries of the electrodes relative to each other, like for example edges which are not parallel to each other, or wrinkles in the electrode layer because of improper handling e.g. by an installer wearing gloves.

The electrode layer of the electrode foil according to the invention is electrically conductive. The expression "electrically conductive" or "conductive" is meant to exclude the property of electrically insulating, but to include the property of electrically semiconductive. The electrode layer may thus be semiconductive. The electrode layer and/or any portion of it may comprise metal or a layer of metal. The electrode layer and/or any portion of it may comprise a conductive polymer or a layer of conductive polymer. The electrode layer and/or any portion of it may comprise an electrically conductive coating. The coating may be supported by the carrier film. The thickness of the electrode layer and/or any portion of it may be between 1 micrometer and 1 millimeter. The electrode layer and/or any portion of it may be conformable such that the electrode foil is conformable around the circumference of an exposed insulation layer of a MV/HV cable.

The electrode layer comprises a sensing electrode portion and a first auxiliary electrode portion. "Portions", in the context of this disclosure, are areas of the electrode layer which appear arranged sideways from each other when looking perpendicularly at the electrode layer, so that two portions of the electrode layer cannot overlap.

The sensing electrode portion and the first auxiliary electrode portion may be arranged in the same plane. The expression "in the same plane" refers to a situation where the electrode foil is flattened and the electrode layer is flat. The electrode layer may thus comprise, in the same plane, a sensing electrode portion and a first auxiliary electrode portion

The sensing electrode portion of the electrode layer may have a rectangular shape, when the electrode layer is flat.

Generally, the sensing electrode portion may extend, in one direction in the plane of the electrode layer, far enough to extend around the full circumference of the exposed insulation layer of a typical MV/HV power cable. Generally, the sensing electrode portion may extend, in one direction in the plane of the electrode layer, further than the full circumference of the exposed insulation layer, so that it can overlap with itself when applied on the insulation layer. Specifically, it may extend, in one direction in the plane of the electrode layer, between 1 cm (centimeter) and 15 cm, between 0,5 cm and 10 cm, between 0,3 cm and 8 cm or between 0,2 cm and 5 cm. Generally, the sensing electrode portion may have two parallel edges.

The first auxiliary electrode portion of the electrode layer is electrically isolated from the sensing electrode portion. This is to say that the first auxiliary electrode portion and the sensing electrode portion are not electrically connected with each other before any wires or electrical contacts or connections are attached to them.

The first auxiliary electrode portion is electrically conductive. The first auxiliary electrode portion may comprise the same or a different material than the sensing electrode portion. It may have the same or a different thickness than the sensing electrode portion.

The first auxiliary electrode portion may have a rectangular shape, when the electrode layer is flat. Generally, the first auxiliary electrode portion may extend, in one direction in the plane of the electrode layer, far enough to extend around the full circumference of the exposed insulation layer of a typical MV/HV power cable without overlapping itself. Specifically, it may extend, in one direction in the plane of the electrode layer, between 1 cm (centimeter) and 15 cm, between 0,5 cm and 10 cm, between 0,3 cm and 8 cm or between 0,2 cm and 5 cm. Generally, the first auxiliary electrode portion may have two parallel edges. Alternatively, the first auxiliary electrode portion may extend, in one direction in the plane of the electrode layer, further than the full circumference of the exposed insulation layer, so that it can overlap with itself when applied circumferentially on the insulation layer.

The electrode foil of the present disclosure comprises a non-conductive carrier film, which carries both the sensing electrode portion and the first auxiliary electrode portion. The carrier film may have two major surfaces, a first major surface and an opposed second major surface. The carrier film may provide mechanical stability to the electrode foil. It may serve as a carrier or support for the electrode layer. It may comprise the adhering surface portion. It may serve as a carrier or support for an adhesive layer comprising the adhering surface portion. The carrier film may comprise a polymeric material. It may comprise, for example, polyester, polyvinylchloride, polyethylene, polypropylene, EPDM (ethylene propylene diene monomer), paper and/or non-conductive silicone. The carrier film may comprise a plurality of layers. Each of the layers may comprise a polymeric material, like for example polyester, polyvinylchloride, polyethylene, polypropylene, EPDM, or non-conductive silicone, and/or it may comprise paper. Generally, the carrier film may be conformable such that it can conform around the circumference of an exposed insulation layer of a MV/HV power cable. The thickness of the carrier film may be, for example, between 0,1 micrometer and 1 millimeter. Specifically, it may be between 1 micrometer and 100 micrometers.

A layer or a plurality of layers may be arranged between the carrier film and the sensing electrode portion. A layer or a plurality of layers may be arranged between the carrier film and the first auxiliary electrode portion. The carrier film may comprise heat stabilizers, so that it can withstand elevated temperatures of a MV/HV cable for long times, e.g. for longer than a year or for longer than 10 years.

Generally, an electrode foil according to the present invention may be attachable to an exposed insulation layer of a MV/HV power cable. Specifically, it may be attachable to an exposed main insulation layer of a MV/HV power cable.

An electrode foil according to the present invention may comprise an adhesive layer. The adhesive layer may comprise the adhering surface portion. Providing an adhesive layer may be a particularly cost-effective way of allowing the electrode foil to be attached to an insulation layer of a power cable. Specifically, the adhesive layer may be arranged on the carrier film. While one side of the adhesive layer faces the carrier film, the opposed side of the adhesive layer is exposed and provides the adhering surface portion. The adhering surface of the adhesive layer, or only a portion of it, can be brought into contact with the insulation layer of the power cable. Depending on the type of adhesive, an appropriate amount of pressure or heat makes the adhering surface stick to the insulation layer, whereby the electrode foil is attached to the insulation layer.

The adhesive layer may comprise, for example, a pressure-sensitive adhesive or a heat-activatable adhesive. The thickness of the adhesive layer may be, for example, between 0,1 micrometer and 500 micrometers, specifically it may be between 1 micron and 100 microns. Generally, the adhesive layer may be conformable such that it can conform around the circumference of an exposed insulation layer of a MV/HV power cable. The adhesive layer may comprise a material that is selected appropriately to adhere well to the surface material of an exposed insulation layer of a MV/HV power cable, such as XLPE, EPR, PE.

The adhesive layer may be arranged directly on a major surface of the carrier film. Alternatively, a layer or a plurality of layers may be arranged between the carrier film and the adhesive layer. In particular the electrode layer may be arranged between the carrier film and the adhesive layer, as is described in more detail below. Generally, the adhesive layer may comprise heat stabilizers, so that it can withstand elevated temperatures of a MV/HV cable for long times, e.g. for longer than a year or for longer than 10 years.

The adhesive layer may comprise a single portion or a plurality of separate portions. Separate portions of an adhesive layer comprising a plurality of separate portions may be separated by areas having no adhesive or by areas comprising non-adhesive material. A separate portion of the adhesive layer may be co-extensive with the sensing electrode portion. A separate portion of the adhesive layer may be co-extensive with the first auxiliary electrode portion and/or with a second auxiliary electrode portion.

The sensing electrode portion and the first auxiliary electrode portion may be arranged on one side, i.e. on the side of one major surface, of the carrier film. They may be arranged on one major surface of the carrier film, e.g. directly on one major surface of the carrier film. This arrangement facilitates manufacturing of the electrode foil, because the sensing electrode portion and the first auxiliary electrode portion may then be applied, e.g. coated, in one single step. This arrangement also may allow for the sensing electrode portion and the first auxiliary electrode portion to lie in a same plane, when the electrode foil is flat, so that these portions have the same distance to the inner conductor of the power cable when the electrode foil is attached to the exposed insulation layer of the power cable. This, in turn, may under specific circumstances result in a higher accuracy of the voltage sensor.

The electrode foil may be conformable such that it can be arranged circumferentially on the exposed insulation layer of a medium or high voltage power cable. The electrode layer and the carrier film and the adhering surface portion may be conformable such that the electrode foil can be arranged circumferentially on the exposed insulation layer of a medium or high voltage power cable. A conformable electrode foil is quicker and easier to attach circumferentially around the circumference of the exposed insulation layer. Circumferential arrangement of the electrode foil and in particular of the sensing electrode portion may increase the sensing accuracy of the voltage sensing. Circumferential arrangement of the first auxiliary electrode portion may be better suitable for shaping the electrical field in the vicinity of the sensing electrode portion and thereby increase the sensing accuracy of the voltage sensing.

Alternatively, the electrode foil may be non-conformable, e.g. stiff or rigid. Such a non-conformable electrode foil may be pre-formed such as to have a shape that corresponds to a shape of an outer surface of an insulation layer of a power cable, so that it can be attached on that insulation layer.

The sensing electrode portion and the first auxiliary electrode portion may be separated by a non-conductive gap. The sensing electrode portion may have an edge, e.g. a straight edge, adjacent to the gap. The first auxiliary electrode portion may have an edge, e.g. a straight edge, adjacent to the gap, opposite to the edge of the sensing electrode portion. The edge of the sensing electrode portion and the opposite edge of the first auxiliary electrode portion may be separated by the non-conductive gap. The edge of the sensing electrode portion and the opposite edge of the first auxiliary electrode portion may be parallel to each other. Generally, an edge of the sensing electrode portion and an opposite edge of the first auxiliary electrode portion may be separated by a non-conductive gap, and said edge of the sensing electrode portion and said opposite edge of the first auxiliary electrode portion may be parallel to each other.

The electrode layer may further comprise a second auxiliary electrode portion, electrically isolated from the sensing electrode portion. The second auxiliary electrode portion may have the same chemical, physical and geometric properties as described above for the first auxiliary electrode portion. A second auxiliary electrode portion may help in shaping the electric field in the vicinity of the sensing electrode portion even better than would be possible with the first auxiliary electrode portion alone. A more symmetric field shape may increase the accuracy of the sensing of the voltage of the inner conductor even further. The presence of a second auxiliary electrode portion may reduce parasitic capacitance and thereby increase the accuracy of the voltage sensor.

Generally, and independent of other features, the second auxiliary electrode portion may extend, in one direction in the plane of the electrode layer, further than the full circumference of the exposed insulation layer, so that it can overlap with itself when applied on the insulation layer.

Alternatively, an electrode foil according to the invention, comprising a sensing electrode portion and a first auxiliary electrode portion on one side of the carrier film, may comprise a second auxiliary electrode portion which is arranged on the other, i.e. on an opposite, side of the carrier film. In other words, the sensing electrode portion and the first auxiliary electrode portion may be arranged on a first major surface of the carrier film, while the second auxiliary electrode may be arranged on a second, opposed major surface of the carrier film.

Independent of other features, the first auxiliary electrode portion and the second auxiliary electrode portion may be electrically connected with each other. This may provide for a particularly efficient field-shaping, and/or may facilitate a simpler electrical setup. Auxiliary electrode portions connected with each other may also reduce parasitic capacitance and thereby increase the accuracy of the voltage sensor. Alternatively, the first auxiliary electrode portion and the second auxiliary electrode portion may be electrically isolated from each other. This may allow the electrode portions being on different electrical potential, which in turn may allow for greater control in field shaping.

The second auxiliary electrode portion may be arranged in the same plane as the first auxiliary electrode portion. It may be arranged in the same plane as the first auxiliary electrode portion when the electrode layer is flat. Arrangement of the two auxiliary electrode portions in the same plane may allow for a more efficient shaping of the electric field in the vicinity of the sensing electrode portion, which may result in higher accuracy of the voltage sensing. Also, an electrode foil in which both auxiliary electrode portions are arranged in the same plane may be more cost-efficient to manufacture than other electrode foils, because both portions can be applied in a single manufacturing step, e.g. in a single coating step.

The first auxiliary electrode portion, the second auxiliary electrode portion and the sensing electrode portion may be arranged in the same plane when the electrode foil is flat. This may facilitate more cost-effective production, because three portion of the electrode layer can be manufactured, e.g. coated, in a single step. Arranging all three electrode portions in a single plane may also be beneficial for the accuracy of the voltage sensing, because all three electrode portions may then have the same distance to the inner conductor of the power cable, when the electrode foil is applied circumferentially to the insulation layer of the power cable.

In an electrode foil having a second auxiliary electrode portion, the sensing electrode portion may be arranged between the first auxiliary electrode portion and the second auxiliary electrode portion. Such an arrangement may allow for a symmetric shaping of the electric field in the vicinity of the sensing electrode portion, which may result in even higher accuracy of the voltage sensing. This arrangement may also allow to reduce parasitic capacitance, which in turn may increase the accuracy of the voltage sensor.

The sensing electrode portion and the second auxiliary electrode portion may be separated by a non-conductive gap. The sensing electrode portion may have an edge, e.g. a straight edge, adjacent to the gap. The second auxiliary electrode portion may have an edge, e.g. a straight edge, adjacent to the gap, opposite to the edge of the sensing electrode portion. The edge of the sensing electrode portion and the opposite edge of the second auxiliary electrode portion may be separated by the non-conductive gap. The edge of the sensing electrode portion and the opposite edge of the second auxiliary electrode portion may be parallel to each other. Generally, an edge of the sensing electrode portion and an opposite edge of the second auxiliary electrode portion may be separated by a non-conductive gap, and said edge of the sensing electrode portion and said opposite edge of the second auxiliary electrode portion may be parallel to each other.

In an electrode foil according to the invention, comprising an adhesive layer comprising the adhering surface portion, the carrier film may be arranged between the adhesive layer and the electrode layer. This arrangement may facilitate cost-effective manufacturing of the electrode foil, because it may allow to obtain the electrode foil by applying the electrode layer on the non-adhesive side of an existing adhesive foil, e.g. self-adhesive, foil. Also, this arrangement may be beneficial in that it avoids direct contact between the electrode layer and the adhesive layer, thereby preventing any undesired chemical interaction between them.

In an electrode foil comprising an adhesive layer comprising the adhering surface portion, in which the carrier film is arranged between the adhesive layer and the electrode layer, a portion of the carrier film may not be covered by the adhesive layer. Such an adhesive-free portion of the carrier film may serve as a flap. A flap may facilitate handling of the electrode foil before, during or after application to the insulation layer of the power cable. It may also make it easier to establish an electrical contact with the electrode layer, because an adhesive-free portion of the carrier film can be folded over such that the electrode layer is easier accessible.

Alternatively, In an electrode foil according to the invention, comprising an adhesive layer comprising the adhering surface portion, the electrode layer may be arranged between the carrier film and the adhesive layer. This arrangement may allow the carrier film to act as a protective layer for the electrode layer, when the electrode foil is applied to the insulation layer of the power cable via the adhesive layer. Also, this arrangement may avoid the carrier film to be located between the electrode layer and the inner conductor of the power cable, which in turn may prevent electrical interference of the carrier film with the function of the electrode layer. Specifically, it may reduce or eliminate an electrical influence of the carrier film on the properties of the dielectric of the sensing capacitor, which is formed by the sensing electrode portion as a first sensing electrode and the inner conductor as a second sensing electrode.

In an electrode foil in which the electrode layer is arranged between the carrier film and the adhesive layer, a portion of the electrode layer may not be covered by the adhesive layer. In particular, a portion of the sensing electrode portion of the electrode layer may not be covered by the adhesive layer. Such an adhesive-free portion of the electrode layer may serve as a contact portion, which can be folded back such that a part of the electrode layer is accessible and can be electrically contacted, while other portions, not folded back, are protected under the carrier film.

An electrode foil according to the invention may comprise a carrier film which comprises the adhering surface portion. The adhering surface portion may thus be a portion of a surface of the carrier film. Such a carrier film may provide advantages in manufacturing cost, because a dedicated adhesive layer may not be required. An adhering surface portion may be a surface portion that can adhere to other surfaces. The adhering surface portion may be a surface portion that can adhere to other surfaces in an adhesiveless manner, e.g. through static forces, or capillary forces.

The adhering surface portion may be a self-adhering surface portion. A self-adhering surface portion is a surface portion of the carrier film that can adhere to other surface portions of the carrier film without requiring adhesive, such as, for example, a surface of a self-fusing silicone material. Such self-fusing silicone material can adhere to itself (i.e. one portion of a layer of the material can adhere to another portion of the layer or to a portion of another layer of the material), if applied under tension and/or pressure. By making the adhering surface portion of the carrier film adhere to another surface portion of the carrier film, the two portions of the carrier film can be attached to each other, such that the carrier film can be arranged circumferentially around the insulation layer of the power cable in a belt-like manner, and held in place by friction between the carrier film and the insulation layer.

The present invention also provides the use of a foil comprising
a) an electrode layer comprising two electrode portions, electrically isolated from each other;
b) a non-conductive carrier film carrying the two electrode portions, and
c) an adhering surface portion
as an electrode assembly of a voltage sensor, for arrangement on an exposed insulation layer of a medium or high voltage power cable.
This new use of such a foil facilitates the integration of a sensing electrode (for sensing the voltage of the inner conductor of the cable in a capacitive manner) and of a first auxiliary electrode (for shaping the electrical field in the vicinity of the sensing electrode) into a MV/HV power cable. One of the electrode portions of the foil is operable as one electrode of a sensing capacitor for sensing a voltage of the inner conductor of the MV/HV power cable, the other electrode of the sensing capacitor being the inner conductor of the cable. The second electrode portion on the foil is operable as a field-shaping or guard electrode. The second electrode portion may be connected to electrical ground and/or to the grounding layer or shielding layer of the HV/MV power cable. The two electrode portions of the foil may be arranged in the same plane when the foil is flat.

The present invention also provides a medium or high voltage power cable comprising an inner conductor and an insulation layer surrounding the inner conductor, further comprising an electrode foil as described above, wherein the electrode foil is attached to the insulation layer. Such a cable may be prepared for quick and easy connection of electric or electronic components, which in conjunction with the electrode foil form a highly accurate capacitive voltage sensor for sensing the voltage of the inner conductor of the cable versus electrical ground.

The invention will now be described in more detail with reference to the following Figures exemplifying particular embodiments of the invention:
- Fig. 1: Perspective view of a portion of a stripped power cable with two electrode foils according to the present invention;
- Fig. 2: Perspective view of a third electrode foil according to the present invention;
- Fig. 3: Perspective view of a fourth electrode foil according to the present invention;
- Fig. 4: Perspective view of a fifth electrode foil according to the present invention;
- Fig. 5: Perspective view of a sixth electrode foil according to the present invention, applied on a stripped power cable;
- Fig. 6: Cross-section of the sixth electrode foil and the power cable;
- Fig. 7: Perspective view of a seventh electrode foil according to the invention;
- Fig. 8: Perspective view of an eighth electrode foil according to the invention, not comprising an adhesive layer; and
- Fig. 9: Cross-section of the eighth electrode foil applied on a stripped power cable.

In the Figures, like elements are provided with the same reference numbers. Some dimensions are exaggerated for greater clarity. Some elements of the Figures are not to scale.

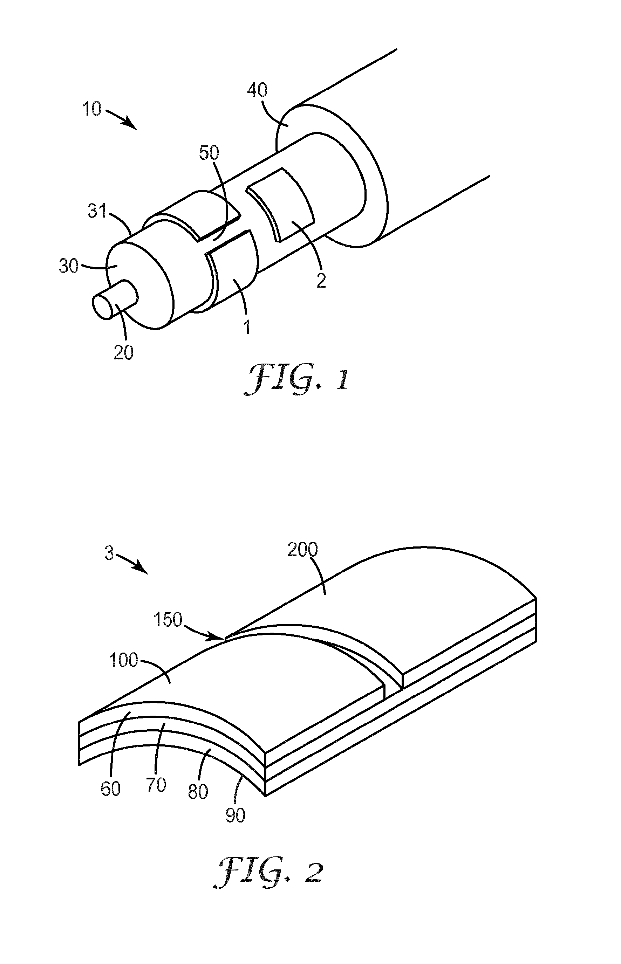

**Figure 1** shows, in a perspective view, a medium-voltage power cable 10. The cable 10 comprises an inner conductor 20, which has a diameter of about 3 cm, and which is surrounded by a main insulation layer 30. The cable 10 is shown partially stripped, so that the main insulation layer 30 is exposed and accessible. In an unstripped portion of the cable 10, the cable sheath 40 is visible. The cable 10 defines axial, radial and circumferential directions.

Two electrode foils 1, 2 according to the invention are attached to the exposed main insulation layer 30, namely to its radially outer surface 31. Each electrode foil 1, 2 provides two electrodes (not visible in Figure 1) for sensing, in a capacitive manner, the voltage of the inner conductor 20 versus ground and shaping the electrical field. The construction of the electrode foils 1, 2 will be described below. Both electrode foils 1, 2 are attached along the circumference of the main insulation layer 30, i.e. they are arranged circumferentially on the main insulation layer 30. The first electrode foil 1 extends along almost the full circumference of the main insulation layer 30, leaving only a small gap 50 between its opposed ends. The second electrode foil 2 extends only to a smaller portion of the circumference of the main insulation layer 30. However, because it follows the circumference of the main insulation layer 30, it is also considered to be arranged circumferentially with respect to the main insulation layer 30.

The first electrode foil 1 is operable as part of a capacitive voltage sensor (not shown), just as the second electrode foil 2 is operable as part of a capacitive voltage sensor (not shown). In reality, however, two voltage sensors will rarely be installed on the same cable 10 at such a short distance from each other.

Figure 2 shows, in a perspective view, a further, third electrode foil 3 according to the present invention. It can be applied to the main insulation layer 30 of a cable 10 just like the electrode foils 1, 2 shown in Figure 1. The electrode foil 3 is shown with a slight curvature, so that it becomes evident which side of it will be facing radially inward towards the inner conductor 20, and which side will face radially outward, when the electrode foil 3 is applied on the main insulation layer 30. The actual curvature may be different when the electrode foil 3 is applied to the main insulation layer 30 of a specific cable 10. The electrode foil 3 comprises three layers: an electrode layer 60, a carrier film 70, and an adhesive layer 80. The electrode foil 3, however, is conformable and can lie flat.

The electrode layer 60 is electrically conductive and is applied directly on the radially outer surface of the carrier film 70. It has two distinct portions, which are arranged side by side to each other, in the same plane: a sensing electrode portion 100 and a first auxiliary electrode portion 200. The sensing electrode portion 100 and the first auxiliary electrode portion 200 are electrically isolated from each other. They are made by coating respective portions of the carrier film 70 with a thin copper layer. A non-conductive gap 150 separates the sensing electrode portion 100 and the first auxiliary electrode portion 200.

The carrier film 70 is continuous. It is electrically non-conductive and mechanically conformable in order to allow attachment of the electrode foil 3 around the circumference of the main insulation layer 30 of a power cable 10 as shown in Figure 1.

The adhesive layer 80 covers the entire radially inner major surface of the carrier film 70. It is thus arranged on the side of the carrier film 70 which is opposite to the side on which the electrode layer 60 is arranged. The exposed surface (the lower surface, in Figure 2) of the adhesive layer 80 provides an adhering surface 90, by which the electrode foil 3 can be attached to the outer surface 31 of the main insulation layer 30. The adhesive layer 80 comprises a pressure-sensitive adhesive, suitable for attaching the electrode foil 3 to the outer surface 31 of the main insulation layer 30. Before use, the adhering surface 90 is protected by a liner (not shown).

Once the electrode foil 3 is applied on the main insulation layer 30, the sensing electrode portion 100 and the inner conductor 20 of the power cable 10 can be operated as electrodes of a sensing capacitor for sensing the voltage of the inner conductor 20 versus electrical ground. A portion of the main insulation layer 30 and a portion of the adhesive layer 80 form the dielectric of this sensing capacitor. The sensing capacitor may be operated as the high-voltage capacitor in a capacitive voltage divider, which further comprises a low-voltage capacitor, electrically arranged between the high-voltage capacitor and ground. A voltage picked up between the high-voltage capacitor and the low-voltage capacitor is indicative of the voltage of the inner conductor 20 versus electrical ground.

In order to electrically connect the high-voltage capacitor to the low-voltage capacitor, an electrical contact to the sensing electrode portion 100 of the electrode layer 60 is required. Such a contact can be established, for example, by a pressure contact to the sensing electrode portion 100, or by glueing a contact to the sensing electrode portion 100 with an electrically conductive glue, or by soldering a contact to the sensing electrode portion 100.

Since the sensing electrode portion 100 is not on electrical ground when the cable 10 is in use, the shape of the electric field in the vicinity of the sensing electrode portion 100 is not as cylindrically-symmetric as it would be in a portion of the cable 10 which has a cylindrical grounding electrode layer surrounding the inner conductor 20 and the main insulation layer 30. In general, however, the more cylindrically-symmetric the electric field in the vicinity of the sensing electrode portion 100, the more accurate the voltage sensing. In order to shape the electric field such as to be more cylindrically-symmetric in the vicinity of the sensing electrode portion 100, a field-shaping or guard electrode is desirable. The first auxiliary electrode portion 200 can be operated as such a field-shaping electrode. It may, for example, be electrically connected to ground, either by having a grounded semiconductive layer of the cable 10 be in contact with the first auxiliary electrode portion 200, or by a separate grounding wire, in electrical contact with the first auxiliary electrode portion 200. The electrical field will be more cylindrically-symmetric if the first auxiliary electrode portion 200 surrounds the inner conductor 20 around a full circumference. In that regard, the electric field will be more cylindrically-symmetric in the electrode foil 1 than in the electrode foil 2, shown in Figure 1.

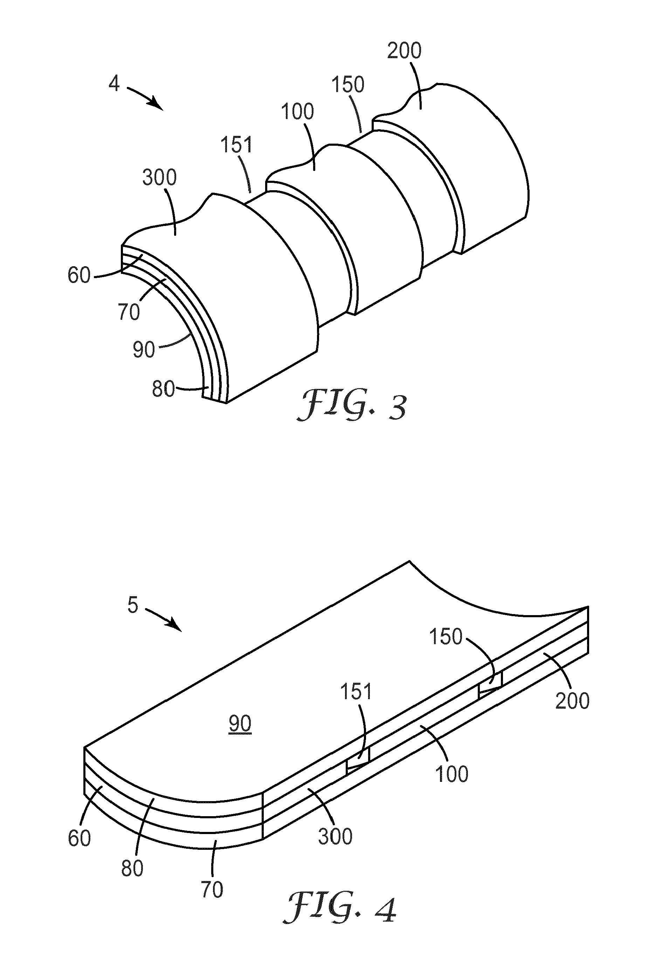

While the first auxiliary electrode portion 200 enhances the symmetry of the electric field on one side of the sensing electrode portion 100 on the electrode foil shown in Figure 2, an even more symmetric field can be obtained if a further, second auxiliary electrode portion 300 is arranged on the electrode foil. A part of such an electrode foil 4 according to the invention is shown, in a perspective view, in **Figure 3**. While the adhesive layer 80 with the adhering surface 90 and the carrier film 70 are identical to the corresponding layers 80, 70 of the electrode foil 3 shown in Figure 2, the electrode layer 60 comprises the sensing electrode portion 100, the first auxiliary electrode portion 200 and a second auxiliary electrode portion 300. The second auxiliary electrode portion 300 lies in the same plane as the first auxiliary electrode portion 200 and the sensing electrode portion 100 (when the electrode foil 4 is flat).

The second auxiliary electrode portion 300 is physically equal to the first auxiliary electrode portion 200. Axially, it is arranged such that the sensing electrode portion 100 is located symmetrically between the first auxiliary electrode portion 200 and the second auxiliary electrode portion 300. Two non-conductive gaps 150, 151 of equal width separate the sensing electrode portion 100 from the first auxiliary electrode portion 200 and the second auxiliary electrode portion 300, respectively. This arrangement results in a very symmetric electric field in the vicinity of the sensing electrode portion 100, when the first auxiliary electrode portion 200 and the second auxiliary electrode portion 300 are put on electrical ground. In a specific embodiment, the first auxiliary electrode portion 200 and the second auxiliary electrode portion 300 are electrically connected with each other, e.g. outside the electrode foil 4.

In the electrode foils 3 and 4, adhesive layer 80 and electrode layer 60 were arranged on different sides, i.e. on different major surfaces, of the carrier film 70. It may be considered to arrange the electrode layer 60 and the adhesive layer 80 on one side of the carrier film 70, that is, over one and the same major surface of the carrier film 70. An example of such an electrode film 5 according to the invention is shown in **Figure 4**, in a perspective view. In the thickness direction (the direction of a normal on a major surface of the electrode foil 5) of the electrode foil 5, the electrode layer 60 is arranged between the carrier film 70 and the adhesive layer 80, which comprises the adhering surface 90. Except for their arrangement relative to each other, the adhesive layer 80 and the carrier film 70 are similar to the corresponding elements in Figure 3. The electrode layer 60 comprises three electrode portions: a sensing electrode portion 100, a first auxiliary electrode portion 200 and a second auxiliary electrode portion 300. The sensing electrode portion 100 is arranged between the first auxiliary electrode portion 200 and the second auxiliary electrode portion 300. All three electrode portions 100, 200, 300 lie in the same plane, i.e. they lie in the same plane when the electrode foil 5 is flat. The auxiliary electrode portions 200, 300 are separated from the sensing electrode portion 100 by respective gaps 150, 151. The adhesive layer 80 is continuous and extends over the three electrode portions 100, 200, 300 and the gaps 150, 151.

When the electrode foil 5 is attached, via the adhesive layer 80, circumferentially to a cylindrical main insulation layer 30 of a power cable 10, all three electrode portions 100, 200, 300 have about the same distance to the inner conductor 20 of the cable 10.

In all embodiments described so far, when attached, the adhesive layer 80 is the radially innermost layer of the electrode foils 1, 2, 3, 4, 5. In the embodiment shown in Figure 4 the carrier film 70 constitutes the radially outermost layer and thereby provides mechanical protection for the radially inner layers, in particular for the electrode layer 60. Generally, it should be noted, however, that the carrier film 70 and the electrode layer 60 do not need to be directly adjacent to each other. One or more further layers may be arranged between them in the thickness direction, for example, a layer of adhesive. Similarly, the adhesive layer 80 and the electrode layer 60 do not need to be directly adjacent to each other. One or more further layers may be arranged between them in the thickness direction.

While the arrangement of the carrier film 70 radially outwards of the electrode layer 60 in the electrode foil 5 in Figure 4 is advantageous in that the carrier film 70 provides mechanical protection, an electrical contact to the sensing electrode portion 100 is more difficult to establish than in embodiments where the electrode layer 60 is the outermost layer, when the electrode foil is attached to the main insulation layer 30 of a cable 10. This is because the carrier film 70 covers the entire surface of the sensing electrode portion 100.

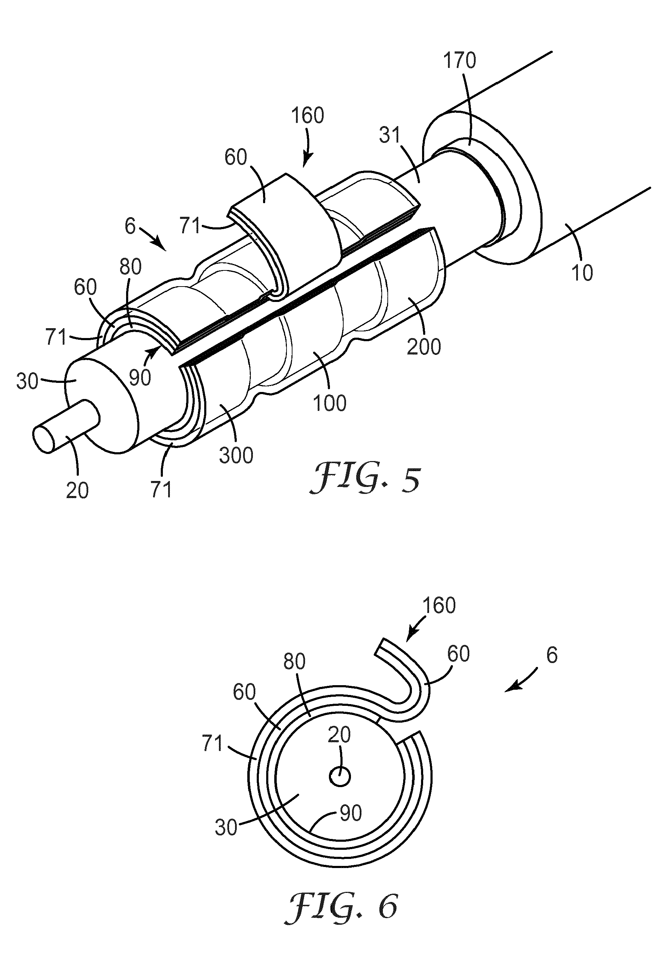

Figure 5 shows, in a perspective view, a further electrode foil 6 according to the invention, which addresses this difficulty. The electrode foil 6 has the same sequence of layers as the electrode foil 5 shown in Figure 4, i.e. an electrode layer 60 is arranged between a carrier film 71 and an adhesive layer 80 comprising an adhering surface 90. The carrier film 71 is drawn transparent, so that the electrode portions are visible, namely a sensing electrode portion 100, arranged between, and in the same plane as, a first auxiliary electrode portion 200 and a second auxiliary electrode portion 300. The electrode foil 6 is attached circumferentially, via the adhesive layer 80, on the outer surface 31 of a main insulation layer 30, which surrounds an inner conductor 20 of a medium-voltage power cable 10.

The electrode foil 6 is conformable and is shaped such as to form a flap 160. In the area of the flap 160, the sensing electrode portion 100 forms a protrusion and extends further, in circumferential direction, than the first auxiliary electrode portion 200 and also further than the second auxiliary electrode portion 300. The sensing electrode portion 100 of the electrode layer 60 is arranged on the carrier film 70, also in the portion forming the flap 160. However, the adhesive layer 80 does not extend into the area of the flap 160. There is thus no adhesive on the flap 160 that might attach the flap 160 to the main insulation layer 30.

This is shown in more detail in **Figure 6**, which shows the electrode foil 6 of Figure 5, applied on the main insulation layer 30, in cross section through the sensing electrode portion 100. The adhesive layer 80 does not cover the entire surface of the electrode layer 60. In particular, the adhesive layer 80 does not cover the entire surface of the sensing electrode portion 100. The absence of the adhesive layer 80 on the flap 160 prevents the flap 160 from sticking to the main insulation layer 30 and allows the flap 160 to be easily folded back, whereby the electrode layer 60 becomes accessible, in particular, a part of the sensing electrode portion 100 of the electrode layer 60 becomes accessible. The accessible part of the sensing electrode portion 100 facilitates establishing an electrical contact to the sensing electrode portion 100, e.g. by a surface contact, by soldering, or through an electrically conductive adhesive.

In an electrode foil, in which the electrode layer 60 is arranged between the adhesive layer 80 and the carrier film 70, not only the sensing electrode portion 100 on the carrier film 70 may form a flap 160, but also the first auxiliary electrode portion 200 on the carrier film 70 may form a flap (not shown) which is free of adhesive, i.e. onto which the adhesive layer 80 does not extend. Similarly, the second auxiliary electrode portion 200 on the carrier film 70 may form a flap (not shown) onto which the adhesive layer 80 does not extend. Such flaps would allow the corresponding parts of the electrode foil 6 to be folded back and thereby to be electrically contacted more easily. Flaps may allow the first and/or the second auxiliary electrode portions 200, 300 to be more easily electrically connectable to a conductive or semiconductive layer 170 (shown in Figure 5) of the cable 10, which is mostly held on electrical ground.

Alternatively to an adhesive-less flap as described above, it is contemplated that the adhesive layer 80 may be present on a flap 160, but be deactivated and made non-adhesive, e.g. by covering it with a non-adhesive material, before applying the electrode foil to a main insulation layer 30 of a cable 10.

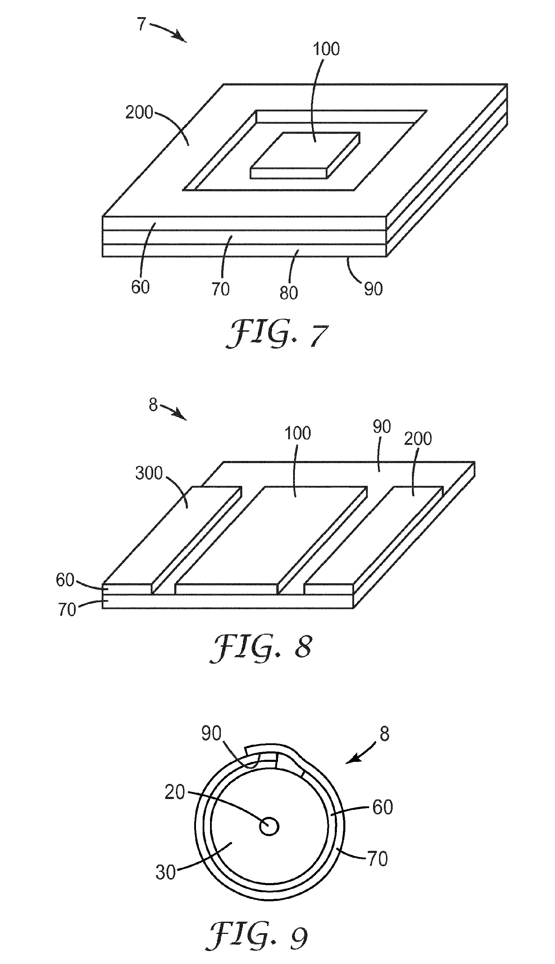

**Figure 7** is a perspective view of a further, seventh electrode foil 7 according to the invention. Its sequence of layers is identical to the sequence of layers of the electrode foil 3 shown in Figure 2, i.e. the adhesive layer 80 is the radially innermost layer, once the electrode foil 7 is applied circumferentially on the main insulation layer of a power cable. The carrier film 70 is arranged between the adhesive layer 80 and the electrode layer 60. The electrode layer 60 comprises a sensing electrode portion 100 and a first auxiliary electrode portion 200, electrically isolated from each other. The first auxiliary electrode portion 200 is arranged on a surface of the carrier film 70 such that it surrounds the sensing electrode portion 100. This arrangement is useful for rendering the electric field between the sensing electrode portion 100 and the inner conductor of the power cable more symmetric. This arrangement also reduces parasitic capacitances in the vicinity of the sensing electrode portion 100 and thereby makes the voltage measurement more accurate.

The concept of arranging electrodes for a power cable sensor on an electrode foil according to the invention may be furthered. In addition to a sensing electrode portion 100, a first auxiliary electrode portion 200 and a second auxiliary electrode portion 300, an electrode foil according to the invention may comprise a fourth electrode portion, e.g. for forming a third auxiliary electrode portion. Any of the auxiliary electrode portions may serve a particular purposes, like for example field shaping, backup sensing electrode, or energy harvesting. Even five or more electrode portions may be provided.

**Figure 8** is a perspective view of an eighth electrode foil 8 according to the invention. It comprises an electrode layer 60 and a carrier film 70. The carrier film 70 carries a sensing electrode portion 100, a first auxiliary electrode portion 200 and a third auxiliary electrode portion 300 of the electrode layer 60 on one of its major surfaces. The electrode portions 100, 200, 300 have the same function as the corresponding electrode portions described before. Specifically, the sensing electrode portion 100 is operable as an electrode of a high-voltage capacitor in a capacitive voltage divider for sensing the voltage of the inner conductor 20 of the power cable. Unlike the previously shown electrode foils, this electrode foil 8 does not comprise an adhesive layer. Rather, the carrier film 70 comprises a self-fusing silicone material, which has the ability to adhere to itself when applied appropriately. Specifically, the material is self-adhering in that its upper surface 90 (in Figure 8) can adhere to its lower surface. The upper surface of the carrier film 70 thus comprises an adhering surface portion 90 which is suitable for attaching the electrode foil 8 circumferentially to an exposed insulation layer of a power cable. The electrode portions 100, 200, 300 comprise an electrically conductive, self-fusing silicone material, applied as a paint on a major surface of the carrier film 70.

This is shown in **Figure 9****,** in which the eighth electrode foil 8 is shown, in cross section through the sensing electrode portion 100, attached circumferentially to an insulation layer 30 of a power cable. The upper surface 90 of the electrode foil 8 forms the radially inner surface of the electrode foil 8, when the electrode foil 8 is attached circumferentially on the insulation layer 30. Where the electrode foil 8 overlaps with itself, the adhering surface portion 90 on the radially inner surface of the carrier film 70 adheres to the radially outer surface of the carrier film 70, so that the electrode foil 8 forms a closed sleeve around the insulation layer 30. The electrode foil 8 is applied under tension in circumferential direction, so that after arrangement around the insulation layer 30, the electrode foil 8 is held in place on the insulation layer 30 by friction. The electrode foil 8 does not actually adhere to the insulation layer 30.

## Claims

1. Electrode foil (1, 2, 3, 4, 5, 6, 7, 8) comprising
a) an electrode layer (60) comprising
- a sensing electrode portion (100), operable as an electrode of a sensing capacitor for sensing a voltage of an inner conductor (20) of a medium or high voltage power cable (10),
- a first auxiliary electrode portion (200), electrically isolated from the sensing electrode portion,
**characterized in that** the electrode foil further comprises
b) a non-conductive carrier film (70, 71) carrying both the sensing electrode portion and the first auxiliary electrode portion, and
c) an adhering surface portion (90) for attaching the electrode foil to an exposed insulation layer (30) of the medium or high voltage power cable.

2. Electrode foil according to claim 1, wherein the sensing electrode portion and the first auxiliary electrode portion are arranged on one major surface of the carrier film.

3. Electrode foil according to one of claims 1 or 2, wherein the electrode foil is conformable such that it can be attached circumferentially to the exposed insulation layer of the medium or high voltage power cable.

4. Electrode foil according to any one of the preceding claims, wherein an edge of the sensing electrode portion and an opposite edge of the first auxiliary electrode portion are separated by a non-conductive gap (150), and wherein said edge of the sensing electrode portion and said opposite edge of the first auxiliary electrode portion are parallel to each other.

5. Electrode foil according to any one of the preceding claims, wherein the electrode layer further comprises a second auxiliary electrode portion (300), electrically isolated from the sensing electrode portion.

6. Electrode foil according to claim 5, wherein the second auxiliary electrode portion is arranged in the same plane as the first auxiliary electrode portion.

7. Electrode foil according to claim 6, wherein the sensing electrode portion is arranged between the first auxiliary electrode portion and the second auxiliary electrode portion.

8. Electrode foil (1, 2, 3, 4, 5, 6, 7) according to any one of the preceding claims, further comprising an adhesive layer (80) comprising the adhering surface portion.

9. Electrode foil (3, 4, 7) according to claim 8, wherein the carrier film is arranged between the adhesive layer and the electrode layer.

10. Electrode foil according to claim 8 or claim 9, wherein a portion of the carrier film is not covered by the adhesive layer.

11. Electrode foil (5, 6) according to claim 8, wherein the electrode layer is arranged between the carrier film and the adhesive layer.

12. Electrode foil (6) according to claim 11, wherein a portion of the electrode layer is not covered by the adhesive layer.

13. Electrode foil (8) according to any one of claims 1 to 7, wherein the carrier film comprises the adhering surface portion.

14. Use of a foil (1, 2, 3, 4, 5, 6, 7, 8) comprising
a) an electrode layer (60) comprising two electrode portions, electrically isolated from each other;
b) a non-conductive carrier film (70, 71) carrying both electrode portions; and
c) an adhering surface portion (90);
as an electrode assembly of a voltage sensor, for attachment to an exposed insulation layer (30) of a medium or high voltage power cable (10).

15. Medium or high voltage power cable (10) comprising an inner conductor (20) and an insulation layer (30) surrounding the inner conductor, further comprising an electrode foil (1, 2, 3, 4, 5, 6, 7, 8) according to any one of claims 1 to 13, wherein the electrode foil is attached to the insulation layer (30).
